# EUROPEAN PATENT SPECIFICATION

(11) **EP 3 826 299 B1**
(45) Date of publication and mention of the grant of the patent: **26.02.2025**
(21) Application number: 18927098.6
(22) Date of filing: 20.07.2018
(51) Int. Cl.: H04N 5/926, G01N 21/956, H04N 5/765, H05K 13/08, H04N 9/804

(54) **IMAGE DATA STORAGE DEVICE, AND IMAGE DATA STORAGE METHOD**
BILDDATENSPEICHERUNGSVORRICHTUNG, UND BILDDATENSPEICHERUNGSVERFAHREN
DISPOSITIF DE STOCKAGE DE DONNÉES D'IMAGE, ET PROCÉDÉ DE STOCKAGE DE DONNÉES D'IMAGE

(43) Date of publication of application: 26.05.2021
(73) Proprietor: Fuji Corporation, Chiryu-shi, Aichi 472-8686 (JP)
(72) Inventor: ONO, Keiichi, Chiryu-shi, Aichi 472-8686 (JP); AMANO, Masafumi, Chiryu-shi, Aichi 472-8686 (JP); YOKOI, Yuta, Chiryu-shi, Aichi 472-8686 (JP)
(74) Representative: Grünecker Patent- und Rechtsanwälte PartG mbB
(86) International application number: PCT/JP2018/027293
(87) International publication number: WO 2020/017027

(56) References cited:
- WO-A1-2017/216950
- WO-A1-2017/216950
- WO-A1-2018/123518
- JP-A- 2007 147 354
- JP-A- 2009 273 005
- JP-A- 2011 058 954
- JP-A- 2017 032 340
- US-A1- 2009 202 143
- US-A1- 2015 286 202
- US-A1- 2017 367 229
- US-A1- 2019 247 021
- US-A1- 2019 335 632

## Description

### Technical Field

The present specification discloses a technique related to an image data storage device and an image data storage method.

### Background Art

US 2015/286202 A1 relates to a board production state monitoring system disposed between a component mounting machine and a reflow furnace, and including a camera unit disposed in a board work machine which carries out work for a board, wherein the camera unit is configured to image a progress of the work by using a moving image. A trigger factor detection unit detects at least one of a change factor in which working conditions of the work are changed inside the board work machine in a sign of error occurrence which shows that a working error may occur in the work, as a trigger factor. An imaging start device causes the camera unit to start moving image capturing if the trigger factor detection unit detects the trigger factor.

JP 2011 058954 A relates to a substrate inspection apparatus comprising an imaging means for capturing the actual mounting state of electronic parts as image data. An image processing means is configured for determining the degree of matching between an image indicating the actual mounting state and a correct image indicating the correct mounting state. If image processing judgement means determine that no match is found between image data and reference data, the images are displayed for an inspector to visually compare the images. If the inspector judges that the two images are not the same, he presses a button, in response to which the bad image data is transferred to bad image data memory.

JP 2007 147354 A relates to an inspection machine for inspecting a substrate loaded with electronic components. A defective substrate data acquisition means acquires data of a defective substrate determined to include a defective portion. High compression is performed on the whole substrate image data, while low compression or non-compression is applied to the defective portion image data.

WO 2017/216950 A discloses a component mounting machine for inclusion in a board work line, and which includes an inspection machine having a camera. The inspection machine applies lossless compression of image data when an error occurs, and applies lossy compression when an error does not occur.

An inspector disclosed in Patent Literature 1 includes an inspector main body, defective board data acquisition means, storage data creation means, and data storage means. The inspector main body inspects a board on which an electronic component is mounted. The defective board data acquisition means acquires data of a defective board determined to include a defective portion with respect to inspection result data obtained by the inspection of the inspector main body.

The storage data creation means extracts image data of the entire board and image data of the defective portion from the data of the defective board, and compresses the image data of the entire board with high compression, and compresses the image data of the defective portion with low compression (including non-compression). The data storage means stores the image data of the entire board with high compression and the image data of the defective portion with low compression.

### Patent Literature

Patent Literature 1: JP-A-2007-147354

### Summary of the Invention

### Technical Problem

However, Patent Literature 1 discloses a technique of storing image data by setting a compression ratio in accordance with a portion of a board with respect to an inspected board, and does not disclose handling of image data acquired by a board work machine with respect to a board work after an inspection result is obtained.

In view of such circumstances, the present specification discloses an image data storage device and an image data storage method capable of instructing storage or non-storage of image data to be acquired by a board work machine with respect to a board work after an inspection result is obtained based on an inspection result.

### Solution to Problem

The object of the present invention is to provide an image data storage device and an image data storage method for improving inspection of board work.

This object is solved by the subject-matter of the independent claims.

Embodiments of the present invention are defined by the dependent claims.

### Advantageous Effect of the Invention

With the image data storage device described above, the instruction section is provided. Therefore, the image data storage device can instruct storage or non-storage of the image data acquired by the board work machine with respect to the board work after the inspection result is obtained based on the inspection result. The above description of the image data storage device is also applicable to the image data storage method.

### Brief Description of Drawings

Fig. 1 is a configuration view illustrating a configuration example of board work line WML.
Fig. 2 is a plan view illustrating a configuration example of component mounter WM3.
Fig. 3 is a block diagram illustrating an example of a control block of image data storage device 80.
Fig. 4 is a flowchart illustrating an example of a control procedure by image data storage device 80.
Fig. 5A is a flowchart illustrating an example of a control procedure by instruction section 81.
Fig. 5B is a flowchart illustrating another example of the control procedure by instruction section 81.
Fig. 5C is a flowchart illustrating another example of the control procedure by instruction section 81.
Fig. 5D is a flowchart illustrating another example of the control procedure by instruction section 81.
Fig. 5E is a flowchart illustrating another example of the control procedure by instruction section 81.

### Description of Embodiments

### 1. Embodiments

### 1-1. Configuration Example of Board Work Line WML

In board work line WML, a predetermined board work is performed on board 90.

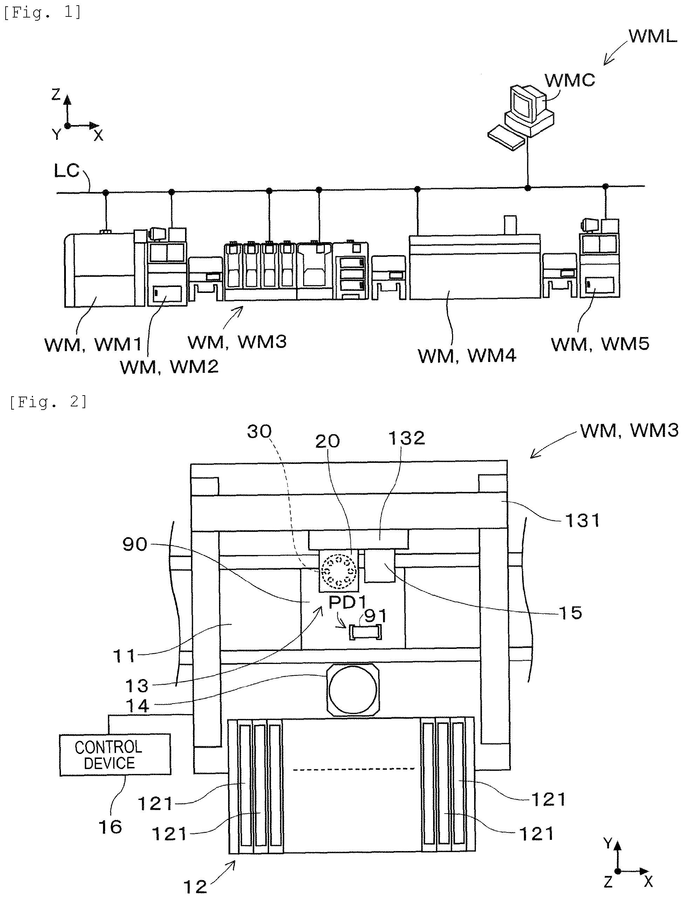

A type and the number of board work machines WM constituting board work line WML are not limited. As illustrated in Fig. 1, board work line WML of the present embodiment includes multiple (five) board work machines WM of printer WM1, printing inspector WM2, component mounter WM3, reflow furnace WM4, and appearance inspector WM5. Multiple (five) board work machines WM are disposed in the order of printer WM1, printing inspector WM2, component mounter WM3, reflow furnace WM4, and appearance inspector WM5 from an upstream side. Board 90 is conveyed in printer WM1 located at a leading end of board work line WML. Then, board 90 is conveyed to a downstream side by a board conveyance device (not illustrated) of board work line WML, and is conveyed out from appearance inspector WM5 located at an end of board work line WML.

Printer WM1 prints solder at a mounting position of each of multiple components 91 on board 90. The solder printed on board 90 is paste-like and has a predetermined viscosity. The solder functions as a bonding material for bonding board 90 and multiple components 91 to be mounted on board 90. Printing inspector WM2 inspects a print state of the solder printed by printer WM1. Component mounter WM3 mounts multiple components 91 on the solder printed by printer WM1. Component mounter WM3 may be one, or may be multiple. As illustrated in Fig. 1, in a case where multiple component mounters WM3 are provided, multiple component mounters WM3 can be shared to mount multiple components 91.

Reflow furnace WM4 heats board 90 on which multiple components 91 are mounted by component mounter WM3, and melts the solder to perform soldering. Appearance inspector WM5 inspects the mounting state of multiple components 91 mounted by component mounter WM3, or the like. Specifically, appearance inspector WM5 recognizes appropriateness of each of multiple components 91 mounted on board 90, mounting states (X-axis coordinate, Y-axis coordinate, and mounting angle) of each of multiple components 91, and the like, and transmits them to management device WMC. As described above, board work line WML can produce a board product by using multiple (five) board work machines WM, conveying boards 90 in order, and executing a production process including an inspection process.

Board work line WML can include, for example, a functional inspector that is board work machine WM. The functional inspector performs a functional inspection of soldered board 90 by reflow furnace WM4. In addition, in board work line WML, a configuration of board work line WML can be appropriately added, and the configuration can be appropriately changed, for example, in accordance with the type of the board product to be produced or the like. Board work line WML may also include, for example, a board work machine WM such as a buffer device, a board supplying device, a board flipping device, a shield mounting device, an adhesive application device, and an ultraviolet ray irradiation device.

Multiple (five) board work machines WM and management device WMC constituting board work line WML are electrically connected by communication section LC. Communication section LC may be wired or wireless. A communication method is not limited. In the present embodiment, a local area network (LAN) is configured by multiple (five) board work machines WM and management device WMC. Therefore, multiple (five) board work machines WM can communicate with each other via communication section LC. In addition, multiple (five) board work machines WM can communicate with management device WMC via communication section LC.

Management device WMC controls multiple (five) board work machines WM constituting board work line WML, and monitors an operation status of board work line WML. Management device WMC stores various data for controlling multiple (five) board work machines WM. Management device WMC transmits the data to each of multiple (five) board work machines WM. In addition, each of multiple (five) board work machines WM transmits the operation status and a production status to management device WMC.

Management device WMC may be provided with an image storage server, a production information server (both of which are not illustrated), or the like. The image storage server can store various image data captured by board work machine WM. The production information server can store various production information related to the production of board 90. For example, the component data included in the production information includes information on a shape of each type of component 91, information on an electrical characteristic, information on a handling method of component 91, or the like. In addition, inspection results of the inspectors such as the printing inspector WM2 and appearance inspector WM5 are included in the production information.

### 1-2. Configuration Example of Component Mounter WM3

Component mounter WM3 mounts multiple components 91 on board 90. As illustrated in Fig. 2, component mounter WM3 includes board conveyance device 11, component supply device 12, component transfer device 13, part camera 14, board camera 15, and control device 16. Board conveyance device 11 is, for example, constituted by a belt conveyor or the like, and conveys board 90 in a conveyance direction (X-axis direction). Board 90 is a circuit board, and at least one of an electronic circuit and an electrical circuit is formed. Board conveyance device 11 carries board 90 into component mounter WM3 and positions board 90 at a predetermined position in the machine. The mounting process of multiple components 91 is completed by component mounter WM3 and then board conveyance device 11 carries out board 90 to an outside of component mounter WM3.

Component supply device 12 supplies multiple components 91 to be mounted on board 90. Component supply device 12 includes multiple feeders 121 provided along the conveyance direction (X-axis direction) of board 90. Each of multiple feeders 121 pitch-feeds a carrier tape (not illustrated) in which multiple components 91 are stored to pickably supply component 91 at a supply position located on a distal end side of feeder 121. In addition, component supply device 12 can also supply a relatively large electronic component (for example, a lead component or the like) as compared with a chip component or the like in a state of being disposed on a tray.

Component transfer device 13 includes head driving device 131 and moving table 132. Head driving device 131 is configured such that moving table 132 is movable by a linear motion mechanism in X-axis direction and Y-axis direction. Moving table 132 is detachably (exchangeably) provided with component mounting head 20 by a clamp member (not illustrated). Component mounting head 20 uses at least one holding member 30 to pick up and hold component 91 supplied by component supply device 12, and mounts component 91 on board 90 positioned by board conveyance device 11. As holding member 30, for example, a suction nozzle, a chuck, or the like can be used.

As part camera 14 and board camera 15, for example, it is possible to use a digital imaging device having an imaging element. As the imaging element, for example, it is possible to use an image sensor such as a charge coupled device (CCD) or a complementary metal oxide semiconductor (CMOS). Part camera 14 and board camera 15 perform imaging based on a control signal transmitted from control device 16. Image data of images captured by part camera 14 and board camera 15 is transmitted to control device 16.

Part camera 14 is fixed to a base of component mounter WM3 such that an optical axis is upward (vertical upward direction) in Z-axis direction. Part camera 14 can image component 91 which is held by holding member 30 from below. Board camera 15 is provided on moving table 132 of component transfer device 13 such that an optical axis is downward (vertical downward direction) in Z-axis direction. Board camera 15 can image board 90 from above.

Control device 16 includes a known central arithmetic unit and a storage device, and is configured of a control circuit (all of which are not illustrated). The central arithmetic unit is a central processing unit (CPU) and can perform various calculation processes. The storage device includes a first storage device and a second storage device. The first storage device is a volatile storage device (random access memory (RAM)) and the second storage device is a non-volatile storage device (read only memory (ROM)). Information, image data, and the like output from various sensors provided in component mounter WM3 are input into control device 16. Control device 16 transmits a control signal to component transfer device 13 based on a control program, a predetermined mounting condition which is set in advance, or the like.

Specifically, control device 16 allows holding member 30 to pick up and hold component 91 supplied by the component supply device 12, and part camera 14 to image holding member 30 holding component 91. Control device 16 performs image processing of the image captured by part camera 14 and recognizes a holding posture of component 91 with respect to holding member 30. For example, control device 16 can recognize the holding posture of component 91 by grasping a portion serving as a reference for positioning, a characteristic portion in the appearance of component 91, or the like by the image processing.

Control device 16 moves holding member 30 above a mounting planned position which is set in advance by a control program or the like. Further, control device 16 corrects the mounting planned position based on the holding posture of component 91 to set the mounting position at which component 91 is actually mounted. The mounting planned position and the mounting position include a rotation angle in addition to the position (X-axis coordinate and Y-axis coordinate). Control device 16 corrects a target position (X-axis coordinate and Y-axis coordinate) of holding member 30 and the rotation angle in accordance with the mounting position. Control device 16 lowers holding member 30 of which the position (X-axis coordinate and Y-axis coordinate) and the rotation angle are corrected to mount component 91 on board 90. Control device 16 repeats the pick-and-place cycle described above to execute the mounting process of mounting multiple components 91 on board 90.

### 1-3. Configuration Example of Image data storage device 80

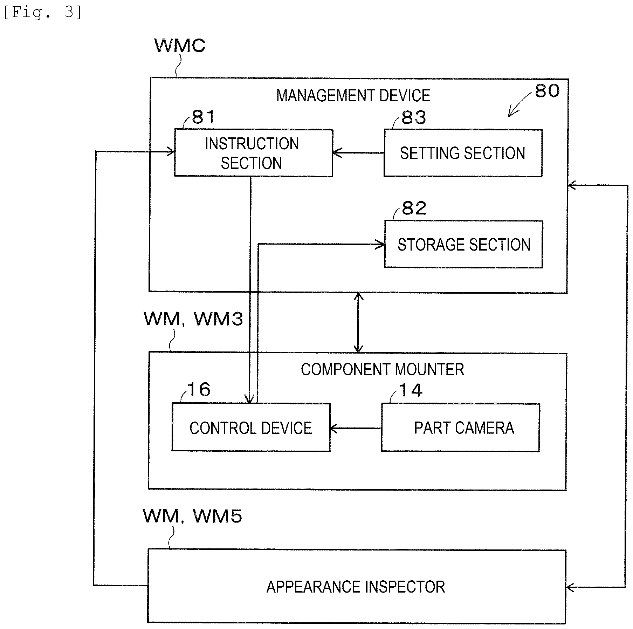

Image data storage device 80 includes instruction section 81 when being regarded as a control block. It is preferable that image data storage device 80 further includes at least one of storage section 82 and setting section 83. As illustrated in Fig. 3, image data storage device 80 of the present embodiment includes instruction section 81, storage section 82, and setting section 83. In addition, image data storage device 80 of the present embodiment is provided in management device WMC. Image data storage device 80 can also be provided in, for example, an image storage server that stores image data captured by board work machine WM.

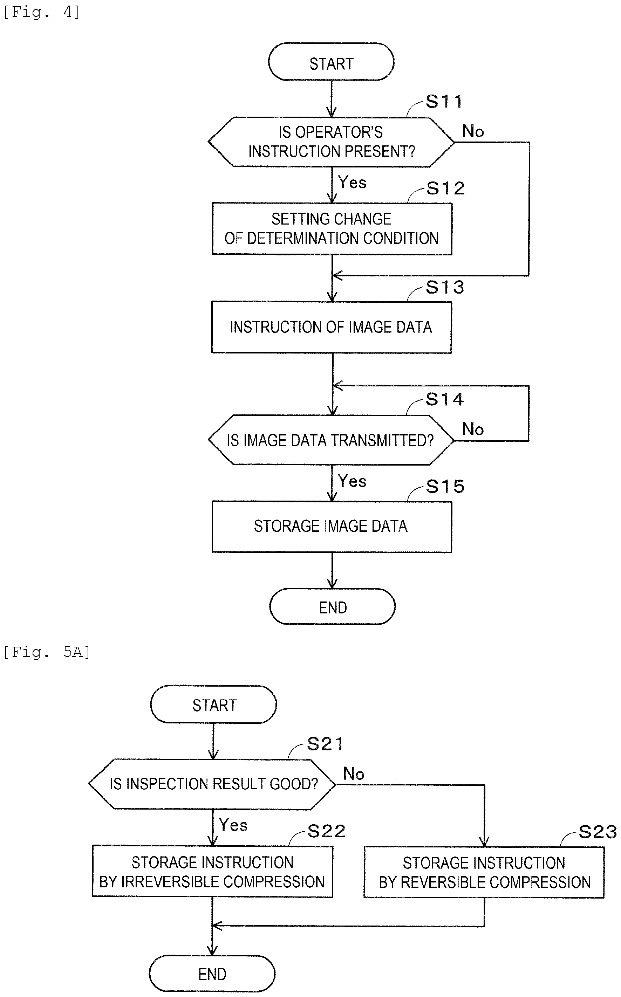

Further, image data storage device 80 executes a control program in accordance with a flowchart illustrated in Fig. 4. Instruction section 81 performs processing illustrated in step S13. Storage section 82 performs a determination illustrated in step S14, and performs processing illustrated in step S15. Setting section 83 performs a determination illustrated in step S11, and performs processing illustrated in step S12. Flowcharts illustrated in Figs. 5A to 5E are detailed processing illustrated in step S13.

### 1-3-1. Instruction Section 81

Instruction section 81 instructs board work machine WM to store or not to store image data acquired with respect to the board work after the inspection result is obtained, based on the inspection result obtained by inspecting whether the board work in board work machine WM that executes the predetermined board work is good or no-good on board 90.

In a case where the inspection result is no-good, it is highly necessary to reproduce the board work performed with high accuracy by board work machine WM from the stored image data to investigate a cause of the defective inspection result. Conversely, in a case where the inspection result is good, it is less necessary to reproduce the board work performed with high accuracy by board work machine WM from the stored image data. In addition, in a case where the inspection result is good, the storage itself of the image data may not be necessary. Therefore, instruction section 81 instructs the storage or non-storage of the image data acquired by board work machine WM with respect to the board work after the inspection result is obtained, based on the inspection result.

It is preferable that instruction section 81 causes the data capacity at the time of storing the image data to be reduced when the inspection result is good, as compared with when the inspection result is no-good. Specifically, it is preferable that instruction section 81 causes the image data to be irreversibly compressed and stored when the inspection result is good, and causes the image data to be reversibly compressed and stored when the inspection result is no-good.

The irreversible compression is a compression method in which a portion of image information included in the image data is lost in a compression process, and it is difficult to restore the image data before the compression with high accuracy as compared with the reversible compression. However, the irreversible compression can reduce the data capacity of the image data as compared with the reversible compression. A joint photographic experts group (JPEG) is an example of the irreversible compression. The reversible compression is a compression method in which image information included in the image data is not lost in the compression process, and the same image data as the image data before the compression is obtained. A graphics interchange format (GIF) and portable network graphics (PNG) are examples of the reversible compression.

As illustrated in Fig. 3, it is preferable that board work machine WM is component mounter WM3 for mounting component 91 on board 90, and the inspection result is an appearance inspection result for each type of component 91 mounted on board 90 by component mounter WM3. As described above, appearance inspector WM5 recognizes an appropriateness of each of multiple components 91 mounted on board 90, a mounting state (X-axis coordinate, Y-axis coordinate, and mounting angle) of each of multiple components 91, or the like. These recognition results are included in the appearance inspection result.

For example, it is assumed that the inspection result obtained by inspecting the mounting state of component 91 of a specific component type is no-good. In this case, for example, at least one of the imaging method (for example, a light exposure time, an aperture, an irradiation method of lighting, or the like) of part camera 14 imaging component 91 which is held by holding member 30 and the imaging processing method of the image data may not be suitable for component 91. Therefore, it is necessary to reproduce the holding state of component 91 or the like with high accuracy from the stored image data, and to investigate the cause of the defective inspection result, or the like.

Therefore, instruction section 81 determines whether the inspection result by appearance inspector WM5 is good (step S21 illustrated in Fig. 5A). In a case where the inspection result is good (in a case of Yes), instruction section 81 causes the image data to be irreversibly compressed and stored (step S22). In a case where the inspection result is no-good (in a case of No), instruction section 81 causes the image data to be reversibly compressed and stored (step S23). Therefore, image data storage device 80 can reduce the data capacity at the time of storing the image data when the inspection result is good. In addition, image data storage device 80 can store the image data such that the board work (holding work of component 91) of component mounter WM3 can be reproduced with high accuracy from the stored image data when the inspection result is no-good.

Instruction section 81 can also store the image data by increasing the compression ratio of the image data when the inspection result is good, as compared with when the inspection result is no-good. As the compression ratio increases, the loss of image information increases, and thereby it is difficult to restore the image data before compression with high accuracy. However, as the compression ratio increases, the data capacity of the image data can be reduced. The compression ratio can be expressed by, for example, 0 to 100%.

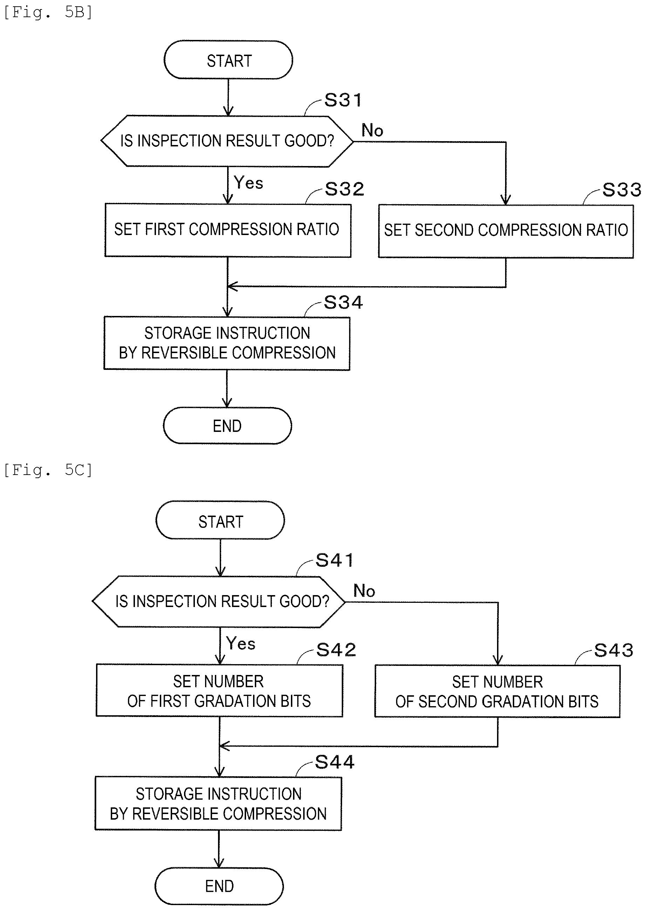

For example, instruction section 81 causes the image data to be reversibly compressed and stored regardless of the inspection result, and increases the compression ratio of the image data when the inspection result is good as compared with when the inspection result is no-good, and thereby it is possible to store the image data. More specifically, instruction section 81 determines whether the inspection result by appearance inspector WM5 is good (step S31 illustrated in Fig. 5B). In a case where the inspection result is good (in a case of Yes), instruction section 81 sets the compression ratio of the image data to a first compression ratio (step S32). In a case where the inspection result is no-good (in a case of No), instruction section 81 sets the compression ratio of the image data to a second compression ratio (step S33). It is assumed that the first compression ratio is higher than the second compression ratio. Instruction section 81 causes the image data to be reversibly compressed and stored at the set compression ratio (step S34). In the present specification, the "setting of the compression ratio" includes, for example, a case where the compression ratio is set by setting a quality level of image storage or the like in addition to a case where the compression ratio itself is set as described above.

Further, as described above, instruction section 81 can irreversibly compress and store the image data when the inspection result is good, reversibly compress and store the image data when the inspection result is no-good, and also set each compression ratio. Specifically, instruction section 81 sets the compression ratio of the image data to the first compression ratio in step S22 illustrated in Fig. 5A. In addition, instruction section 81 sets the compression ratio of the image data to the second compression ratio in step S23 illustrated in Fig. 5A. In either case, image data storage device 80 can reduce the data capacity at the time of storing the image data when the inspection result is good. In addition, image data storage device 80 can store the image data such that the board work (holding work of component 91) of component mounter WM3 can be reproduced with high accuracy from the stored image data when the inspection result is no-good.

Instruction section 81 can also store the image data by reducing the number of gradation bits of the image data when the inspection result is good as compared with when the inspection result is no-good. As the number of gradation bits decreases, the number of colors of the image decreases, and it is difficult to restore the image data before compression with high accuracy. However, as the number of gradation bits decreases, the data capacity of the image data can be reduced. The number of gradation bits can be set to, for example, 8 bits, 12 bits, 15 bits, 16 bits, 18 bits, 24 bits, 30 bits, 32 bits, 36 bits, 42 bits, 48 bits, or the like. For example, in a case where the number of gradation bits is 8 bits, the image is represented by 256 colors. In a case where the number of gradation bits is 24 bits, the image is represented by approximately 16.77 million colors (full color).

For example, instruction section 81 causes the image data to be reversibly compressed and stored regardless of the inspection result, and can store the image data by reducing the number of gradation bits of the image data when the inspection result is good as compared with when the inspection result is no-good. Specifically, instruction section 81 determines whether the inspection result by appearance inspector WM5 is good (step S41 illustrated in Fig. 5C). In a case where the inspection result is good (in a case of Yes), instruction section 81 sets the number of gradation bits of the image data to the number of first gradation bits (step S42). In a case where the inspection result is no-good (in a case of No), instruction section 81 sets the number of gradation bits of the image data to the number of second gradation bits (step S43). It is assumed that the number of first gradation bits is smaller than the number of second gradation bits. Instruction section 81 causes the image data to be reversibly compressed by the set number of gradation bits and causes the image data to be stored (step S44).

Further, as described above, instruction section 81 can irreversibly compress and store the image data when the inspection result is good, reversibly compress and store the image data when the inspection result is no-good, and also set each number of gradation bits. Further, instruction section 81 can irreversibly compress and store the image data when the inspection result is good, reversibly compress and store the image data when the inspection result is no-good, and also set each of both the compression ratio and the number of gradation bits.

Specifically, instruction section 81 sets the number of gradation bits of the image data to the number of first gradation bits in step S22 illustrated in Fig. 5A. In step S23 illustrated in Fig. 5A, Instruction section 81 sets the number of gradation bits of the image data to the number of second gradation bits. In addition, in step S22 illustrated in Fig. 5A, instruction section 81 sets the compression ratio of the image data to the first compression ratio, and sets the number of gradation bits of the image data to the number of first gradation bits. In step S23 illustrated in Fig. 5A, instruction section 81 sets the compression ratio of the image data to the second compression ratio, and sets the number of gradation bits of the image data to the number of second gradation bits. In either case, image data storage device 80 can reduce the data capacity at the time of storing the image data when the inspection result is good. In addition, image data storage device 80 can store the image data such that the board work (holding work of component 91) of component mounter WM3 can be reproduced with high accuracy from the stored image data when the inspection result is no-good.

Instruction section 81 can compress and store the image data when the inspection result is good, and non-compress and store the image data when the inspection result is no-good. In this case, the compression method may be the irreversible compression (for example, JPEG or the like) as described above, or the reversible compression (for example, GIF, PNG, or the like). In addition, a bit map image (BMP) is also an example of the non-compression.

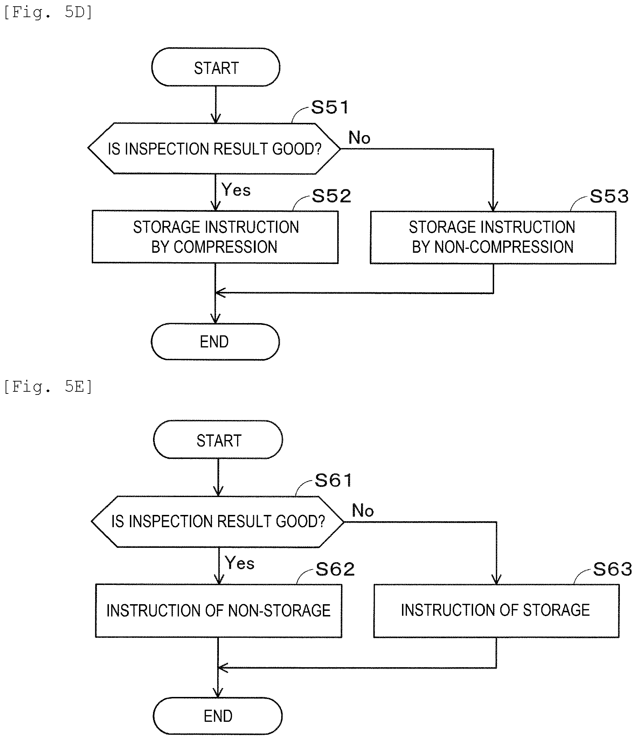

Specifically, instruction section 81 determines whether the inspection result by appearance inspector WM5 is good (step S51 illustrated in Fig. 5D). In a case where the inspection result is good (in a case of Yes), instruction section 81 causes the image data to be compressed and stored (step S52). In a case where the inspection result is no-good (in a case of No), instruction section 81 causes the image data to be non-compressed and stored (step S53). In addition, instruction section 81 can compress and store the image data when the inspection result is good, non-compress and store the image data when the inspection result is no-good, and set each of the number of gradation bits.

Specifically, in step S52 illustrated in Fig. 5D, instruction section 81 sets the number of gradation bits of the image data to the number of first gradation bits. In addition, in step S53 illustrated in Fig. 5D, instruction section 81 sets the number of gradation bits of the image data to the number of second gradation bits. In either case, image data storage device 80 can reduce the data capacity at the time of storing the image data when the inspection result is good. In addition, image data storage device 80 can store the image data such that the board work (holding work of component 91) of component mounter WM3 can be reproduced with high accuracy from the stored image data when the inspection result is no-good.

Instruction section 81 can instruct non-storage of the image data when the inspection result is good. Specifically, instruction section 81 determines whether the inspection result by appearance inspector WM5 is good (step S61 illustrated in Fig. 5E). In a case where the inspection result is good (in a case of Yes), instruction section 81 instructs non-storage of the image data (step S62). In a case where the inspection result is no-good (in a case of No), instruction section 81 instructs storage of the image data (step S63). Therefore, image data storage device 80 can set the data capacity at the time of storing the image data to zero when the inspection result is good. In a case where the image data is stored when the inspection result is no-good, it is preferable that instruction section 81 causes the image data to be reversibly compressed and stored. Therefore, image data storage device 80 can store the image data such that the board work (holding work of component 91) of component mounter WM3 can be reproduced with high accuracy from the stored image data when the inspection result is no-good.

In any of the embodiments described above, it is preferable that instruction section 81 determines that the inspection result is good when at least one state of a first state where the inspection result is good continuously for a predetermined period and a second state where the inspection result is good continuously for a predetermined count number. The predetermined period of the first state and the predetermined count number of the second state can be arbitrarily set. The predetermined period of the first state and the predetermined count number of the second state may be set for each type of component 91. Thus, for example, image data storage device 80 easily determines whether the imaging method of part camera 14 and the imaging processing method of the image data described above are suitable for component 91. For example, in a case where at least one state of the first state and the second state is established, it can be said that the imaging method of part camera 14 and the imaging processing method of the image data are suitable for component 91.

### 1-3-2. Storage Section 82

Storage section 82 stores the image data. It is preferable that storage section 82 is provided in, for example, a non-volatile storage device (read only memory (ROM)). In this case, storage section 82 can store the image data even in a state where power is not supplied. Storage section 82 may be provided in, for example, a storage device such as a flash memory or an electrically erasable programmable read only memory (EEPROM). In addition, storage section 82 may be provided in, for example, a magnetic storage device such as a hard disk drive (HDD), an optical storage device such as an optical disk, or the like.

It is preferable that storage section 82 stores the image data of which data capacity is reduced by board work machine WM. For example, as illustrated in Fig. 3, instruction section 81 instructs control device 16 of component mounter WM3 to perform the storage or non-storage of the image data acquired by component mounter WM3 in relation to the board work (for example, the holding work of component 91) after the inspection result is obtained. Instruction section 81 can also instruct the storage or non-storage of the image data for each type of component 91. For example, control device 16 can temporarily store the image data of the image captured by part camera 14. Control device 16 reduces the data capacity of the image data when the inspection result by appearance inspector WM5 is good, as compared with when the inspection result is no-good, by the method described above.

Storage section 82 determines whether the image data is transmitted from control device 16 of component mounter WM3 (step S14 illustrated in Fig. 4). In a case where the image data is transmitted (in a case of Yes), storage section 82 stores the image data (step S15). In a case where the image data is not transmitted (in a case of No), the control returns to the determination illustrated in step S14, and storage section 82 waits until the image data is transmitted. In a case where instruction section 81 instructs the non-storage of the image data when the inspection result is good, the determination illustrated in step S14 and the processing illustrated in step S15 are omitted. In other words, in this case, image data storage device 80 can omit storage section 82.

Storage section 82 can sequentially store the image data each time the image data is transmitted. In addition, when a predetermined number of pieces of image data is accumulated, storage section 82 can store the predetermined number of pieces of image data at a time or divided into multiple times. In this case, management device WMC may include, for example, a ring buffer capable of temporarily storing multiple image data, or the like. Further, in order to reduce a computing load, management device WMC may include, for example, a direct memory access (DMA) controller or the like. It is preferable that storage section 82 stores unique information capable of identifying the image data, the acquisition date, the acquisition time, version information of the control program of component mounter WM3, and the like, together.

Storage section 82 can also reduce the data capacity of the image data transmitted from board work machine WM and store the image data. In this case, instruction section 81 instructs storage section 82 to perform the storage or non-storage of the image data. For example, control device 16 of component mounter WM3 transmits the image data to storage section 82 without reducing the data capacity of the image data. Storage section 82 stores the data capacity of the image data when the inspection result by appearance inspector WM5 is good by reducing the data capacity as compared with when the inspection result is no-good by the method described above.

### 1-3-3. Setting Section 83

Setting section 83 sets at least one of the predetermined period of the first state and the predetermined count number of the second state in accordance with an instruction of an operator who operates board work machine WM. Management device WMC includes a known input device (for example, a keyboard or the like) and the operator can input at least one of the predetermined period of the first state and the predetermined count number of the second state.

Specifically, setting section 83 determines whether an instruction is issued by the operator (step S11 illustrated in Fig. 4). In a case where there is an instruction by the operator (in a case of Yes), setting section 83 changes at least one of the predetermined period of the first state and the predetermined count number of the second state based on the instruction (input value) by the operator (step S12). In a case where there is no instruction by the operator (in a case of No), the control proceeds to the processing illustrated in step S13. In this case, setting section 83 uses the predetermined period of the first state and the predetermined count number of the second state which are set in advance. The operator can also instruct the parameters previously described (for example, irreversible compression or reversible compression, compression or non-compression, storage or non-storage, compression ratio, the number of gradation bits, and the like). In this case, setting section 83 can also set parameters in accordance with an instruction of the operator.

### 2. Others

Board work machine WM may be printer WM1 for printing the solder at the mounting position of component 91 in board 90, the inspection result may be a solder inspection result for each print region PD1 of the solder printed on board 90 by printer WM1. For example, it is assumed that the print state of the solder in a specific print region is determined to be no-good by printing inspector WM2. In this case, for example, at least one of an imaging method (for example, a light exposure time, an aperture, an irradiation method of lighting, or the like) of a camera (not illustrated) that captures an image of the print region and the imaging processing method of the image data may not be suitable for the print region. Therefore, it is necessary to reproduce the print state of the solder in the print region from the stored image data with high accuracy to investigate the cause of the defective inspection result. As described above, the above description of the appearance inspection result of component 91 can be similarly applied to the solder inspection result obtained by inspecting the print state of the solder. Board work machine WM, the board work, the inspection result, and the image data are only examples, and are not limited to those described above.

### 3. Image Data Storage Method

The above description for Image data storage device 80 is also applicable to the image data storage method. Specifically, the image data storage method includes an instruction step. The instruction step instructs storage or non-storage of image data acquired by board work machine WM with respect to a board work after an inspection result is obtained, based on the inspection result obtained by inspecting whether the board work is good or no-good in board work machine WM that executes a predetermined board work on board 90. That is, the instruction step corresponds to the control performed by instruction section 81. Further, it is preferable that the image data storage method includes at least one of a storage step and a setting step. The storage step corresponds to the control performed by storage section 82, and the setting step corresponds to the control performed by setting section 83.

### 4. Example of Effect of Embodiment

Image data storage device 80 includes instruction section 81. Therefore, image data storage device 80 can instruct the storage or non-storage of the image data acquired by board work machine WM with respect to the board work after the inspection result is obtained based on the inspection result. The above description of image data storage device 80 is also applicable to the image data storage method.

### Reference Signs List

80: image data storage device, 81: instruction section, 82: storage section, 83: setting section, 90: board, 91: component, PD1: print region, WM: board work machine, WM1: printer, WM3: component mounter

## Claims

1. A board work line comprising:
a reflow furnace (WM4),
an appearance inspector (WM5) located at an end of the board work line (BWL), wherein the appearance inspector (WM5) is disposed downstream from the reflow furnace (WM4);
an image data storage device for storing images acquired by a board work machine of the board work line, the image data storage device comprising:
an instruction section (81) configured to instruct storage of image data acquired by the board work machine that executes a predetermined board work on a board, with respect to the board work after an inspection result is obtained, based on the inspection result, wherein the board is a circuit board, wherein the instruction section (81) is configured to receive the inspection result from the appearance inspector (WM5), wherein the appearance inspector (WM5) is configured for obtaining the inspection result by inspecting whether the board work is good or no-good in the board work machine,
wherein the instruction section (81) causes the image data to be stored by reducing the number of gradation bits of the image data when the inspection result by the appearance inspector (WM5) is good as compared with when the inspection result by the appearance inspector (WM5) is no-good
wherein the board work machine is a component mounter (WM3) configured to mount a component on the board, and wherein the appearance inspector (WM5) is configured to recognize appropriateness and mounting states of each of multiple components mounted on the board.

2. The board work line according to Claim 1, wherein the image data storage device further comprises a storage section (82) configured to store the image data.

3. The board work line according to Claim 1, wherein the image data storage device further comprises a storage section (82) configured to store the image data, wherein the storage section reduces the number of gradation bits and stores the image data transmitted from the board work machine.

4. The board work line according to any one of Claims 1 to 3, wherein the instruction section (81) causes the image data to be irreversibly compressed and stored when the inspection result is good, and causes the image data to be reversibly compressed and stored when the inspection result is no-good.

5. The board work line according to any one of Claims 1 to 4, wherein the instruction section (81) causes the image data to be stored by increasing a compression ratio of the image data when the inspection result is good as compared with when the inspection result is the no-good.

6. The board work line according to any one of Claims 1 to 3, wherein the instruction section (81) causes the image data to be compressed and stored when the inspection result is good, and causes the image data to be stored in a non-compressed state when the inspection result is no-good.

7. The board work line according to any one of Claims 1 to 6, wherein the instruction section (81) determines that the inspection result is good when at least one state of a first state where the inspection result is good continuously for a predetermined period and a second state where the inspection result is good continuously for a predetermined count number is established.

8. The board work line according to Claim 7, wherein the image data storage device further comprises:
a setting section (83) configured to set at least one of the predetermined period of the first state and the predetermined count number of the second state according to an instruction of an operator operating the board work machine.

9. An image data storage method for storing images acquired by a board work machine of a board work line, wherein the board work machine is a component mounter configured to mount a component on the board, the method comprising:
an instruction step (S13) of instructing storage of image data acquired by the board work machine that executes a predetermined board work on a circuit board, with respect to the board work after an inspection result is obtained, based on the inspection result, wherein the inspection result is obtained from an inspector included in the board work line,
wherein the inspector is configured for obtaining the inspection result by inspecting whether the board work is good or no-good in the board work machine, wherein the inspection result is obtained from an appearance inspector located at an end of the board work line, wherein the appearance inspector is disposed downstream from a reflow furnace of the board work line, and wherein the appearance inspector is configured to recognize appropriateness and mounting states of each of multiple components mounted on the board,
wherein the instruction step (S13) comprises causing the number of gradation bits of the image data to be reduced when the inspection result is good as compared with when the inspection result is no-good.

## Patentansprüche

1. Plattenbearbeitungslinie, umfassend:
einen Aufschmelzofen (WM4),
einen an einem Ende der Plattenbearbeitungslinie (BWL) angeordneten Aussehensprüfer (WM5), wobei der Aussehensprüfer (WM5) stromabwärts vom Aufschmelzofen (WM4) angeordnet ist;
eine Bilddaten-Speichervorrichtung zum Speichern von von einer Plattenbearbeitungsmaschine der Plattenbearbeitungslinie erfassten Bildern, wobei die Bilddaten-Speichervorrichtung umfasst:
einen Anweisungsabschnitt (81), ausgebildet zum Anweisen des Speicherns von von der Plattenbearbeitungsmaschine, die eine vorbestimmte Plattenbearbeitung an einer Platte ausführt, in Bezug auf die Plattenbearbeitung erfassten Bilddaten nach Erhalten eines Prüfergebnisses basierend auf dem Prüfergebnis, wobei die Platte eine Leiterplatte ist, wobei der Anweisungsabschnitt (81) zum Empfangen des Prüfergebnisses vom Aussehensprüfer (WM5) ausgebildet ist, wobei der Aussehensprüfer (WM5) zum Ermitteln des Prüfergebnisses durch Prüfen, ob die Plattenbearbeitung in der Plattenbearbeitungsmaschine in Ordnung oder nicht in Ordnung ist, ausgebildet ist,
wobei der Anweisungsabschnitt (81) das Speichern der Bilddaten durch Verkleinern der Zahl von Gradationsbits der Bilddaten veranlasst, wenn das Prüfergebnis des Aussehensprüfers (WM5) in Ordnung ist im Vergleich dazu, wenn das Prüfergebnis des Aussehensprüfers (WM5) nicht in Ordnung ist,
wobei die Plattenbearbeitungsmaschine ein Komponentenmontierer (WM3) ist, ausgebildet zum Montieren einer Komponente auf der Platte, und wobei der Aussehensprüfer (WM5) zum Erkennen von Eignung und Montagezuständen von jeder der auf der Platte montierten mehreren Komponenten ausgebildet ist.

2. Plattenbearbeitungslinie nach Anspruch 1, wobei die Bilddaten-Speichervorrichtung ferner einen Speicherabschnitt (82), ausgebildet zum Speichern der Bilddaten, umfasst.

3. Plattenbearbeitungslinie nach Anspruch 1, wobei die Bilddaten-Speichervorrichtung ferner einen Speicherabschnitt (82), ausgebildet zum Speichern der Bilddaten, umfasst, wobei der Speicherabschnitt die Zahl von Gradationsbits verringert und die von der Plattenbearbeitungsmaschine gesendeten Bilddaten speichert.

4. Plattenbearbeitungslinie nach einem der Ansprüche 1 bis 3, wobei der Anweisungsabschnitt (81) veranlasst, dass die Bilddaten irreversibel komprimiert und gespeichert werden, wenn das Prüfergebnis in Ordnung ist, und veranlasst, dass die Bilddaten reversibel komprimiert und gespeichert werden, wenn das Prüfergebnis nicht in Ordnung ist.

5. Plattenbearbeitungslinie nach einem der Ansprüche 1 bis 4, wobei der Anweisungsabschnitt (81) das Speichern der Bilddaten durch Erhöhen eines Kompressionsverhältnisses der Bilddaten veranlasst, wenn das Prüfergebnis in Ordnung ist, im Vergleich dazu, wenn das Prüfergebnis nicht in Ordnung ist.

6. Plattenbearbeitungslinie nach einem der Ansprüche 1 bis 3, wobei der Anweisungsabschnitt (81) veranlasst, dass die Bilddaten komprimiert und gespeichert werden, wenn das Prüfergebnis in Ordnung ist, und veranlasst, dass die Bilddaten in einem nicht komprimierten Zustand gespeichert werden, wenn das Prüfergebnis nicht in Ordnung ist.

7. Plattenbearbeitungslinie nach einem der Ansprüche 1 bis 6, wobei der Anweisungsabschnitt (81) bestimmt, dass das Prüfergebnis in Ordnung ist, wenn wenigstens ein Zustand eines ersten Zustands, in dem das Prüfergebnis kontinuierlich über einen vorbestimmten Zeitraum in Ordnung ist, und eines zweiten Zustands, in dem das Prüfergebnis kontinuierlich für eine vorbestimmte Zählerzahl in Ordnung ist, ermittelt wird.

8. Plattenbearbeitungslinie nach Anspruch 7, wobei die Bilddaten-Speichervorrichtung ferner umfasst:
einen Einstellabschnitt (83), ausgebildet zum Einstellen des vorbestimmten Zeitraums des ersten Zustands oder/und der vorbestimmten Zählerzahl des zweiten Zustands gemäß einer Anweisung eines die Plattenbearbeitungsmaschine bedienenden Bedieners.

9. Bilddaten-Speicherverfahren zum Speichern von von einer Plattenbearbeitungsmaschine einer Plattenbearbeitungslinie erfassten Bildern, wobei die Plattenbearbeitungsmaschine ein Komponentenmontierer, ausgebildet zum Montieren einer Komponente auf der Platte, ist, wobei das Verfahren umfasst:
einen Anweisungsschritt zum Anweisen des Speicherns von von der Plattenbearbeitungsmaschine, die eine vorbestimmte Plattenbearbeitung an einer Leiterplatte ausführt, in Bezug auf die Plattenbearbeitung erfassten Bilddaten nach Erhalten eines Prüfergebnisses basierend auf dem Prüfergebnis, wobei das Prüfergebnis von einem in der Plattenbearbeitungslinie enthaltenen Prüfer ermittelt wird,
wobei der Prüfer zum Ermitteln des Prüfergebnisses durch Prüfen, ob die Plattenbearbeitung in der Plattenbearbeitungsmaschine in Ordnung oder nicht in Ordnung ist, ausgebildet ist, wobei das Prüfergebnis von einem an einem Ende der Plattenbearbeitungslinie angeordneten Aussehensprüfer ermittelt wird, wobei der Aussehensprüfer stromabwärts von einem Aufschmelzofen der Plattenbearbeitungslinie angeordnet ist, und wobei der Aussehensprüfer zum Erkennen von Eignung und Montagezuständen von jeder von auf der Platte montierten mehreren Komponenten ausgebildet ist,
wobei der Anweisungsschritt (S13) das Veranlassen umfasst, dass die Zahl von Gradationsbits der Bilddaten verringert wird, wenn das Prüfergebnis in Ordnung ist im Vergleich dazu, wenn das Prüfergebnis nicht in Ordnung ist.

## Revendications

1. Ligne de traitement de cartes comprenant :
un four de refusion (WM4),
un inspecteur d'apparence (WM5) situé à une extrémité de la ligne de traitement de cartes (BWL), dans laquelle l'inspecteur d'apparence (WM5) est disposé en aval du four de refusion (WM4) ;
un dispositif de stockage de données d'image pour stocker des images acquises par une machine de traitement de cartes de la ligne de traitement de cartes, le dispositif de stockage de données d'image comprenant :
une section d'instruction (81) configurée pour ordonner le stockage de données d'image acquises par la machine de traitement de cartes qui exécute un traitement de carte prédéterminé sur une carte, par rapport au traitement de carte après l'obtention d'un résultat d'inspection, sur la base du résultat d'inspection, dans laquelle la carte est une carte de circuit imprimé, dans laquelle la section d'instruction (81) est configurée pour recevoir le résultat d'inspection de l'inspecteur d'apparence (WM5), dans laquelle l'inspecteur d'apparence (WM5) est configuré pour obtenir le résultat d'inspection en inspectant si le traitement de carte est bon ou n'est pas bon dans la machine de traitement de cartes,
dans laquelle la section d'instruction (81) commande le stockage des données d'image en réduisant le nombre de bits de gradation des données d'image quand le résultat d'inspection par l'inspecteur d'apparence (WM5) est bon par rapport au cas où le résultat d'inspection par l'inspecteur d'apparence (WM5) n'est pas bon,
dans laquelle la machine de traitement de cartes est un dispositif de montage de composants (WM3) configuré pour monter un composant sur la carte, et dans laquelle l'inspecteur d'apparence (WM5) est configuré pour reconnaître l'adéquation et les états de montage de chacun des multiples composants montés sur la carte.

2. Ligne de traitement de cartes selon la revendication 1, dans laquelle le dispositif de stockage de données d'image comprend en outre une section de stockage (82) configurée pour stocker les données d'image.

3. Ligne de traitement de cartes selon la revendication 1, dans laquelle le dispositif de stockage de données d'image comprend en outre une section de stockage (82) configurée pour stocker les données d'image, dans laquelle la section de stockage réduit le nombre de bits de gradation et stocke les données d'image transmises en provenance de la machine de traitement de cartes.

4. Ligne de traitement de cartes selon l'une quelconque des revendications 1 à 3, dans laquelle la section d'instruction (81) commande la compression irréversible et le stockage des données d'image quand le résultat d'inspection est bon, et commande la compression réversible et le stockage des données d'image quand le résultat d'inspection n'est pas bon.

5. Ligne de traitement de cartes selon l'une quelconque des revendications 1 à 4, dans laquelle la section d'instruction (81) commande le stockage des données d'image en augmentant un taux de compression des données d'image quand le résultat d'inspection est bon par rapport au cas où le résultat d'inspection n'est pas bon.

6. Ligne de traitement de cartes selon l'une quelconque des revendications 1 à 3, dans laquelle la section d'instruction (81) commande la compression et le stockage des données d'image quand le résultat d'inspection est bon, et commande le stockage des données d'image dans un état non compressé quand le résultat d'inspection n'est pas bon.

7. Ligne de traitement de cartes selon l'une quelconque des revendications 1 à 6, dans laquelle la section d'instruction (81) détermine que le résultat d'inspection est bon quand au moins un état est réglé parmi un premier état où le résultat d'inspection est bon en continu pendant une période prédéterminée et un deuxième état où le résultat d'inspection est bon en continu pendant un nombre de comptage prédéterminé.

8. Ligne de traitement de cartes selon la revendication 7, dans laquelle le dispositif de stockage de données d'image comprend en outre :
une section de réglage (83) configurée pour régler au moins un paramètre parmi la période prédéterminée du premier état et le nombre de comptage prédéterminé du deuxième état selon une instruction d'un opérateur exploitant la machine de traitement de cartes.

9. Procédé de stockage de données d'image destiné à stocker des images acquises par une machine de traitement de cartes d'une ligne de traitement de cartes, dans lequel la machine de traitement de cartes est un dispositif de montage de composants configuré pour monter un composant sur la carte, le procédé comprenant :
une étape d'instruction (S13) consistant à ordonner le stockage de données d'image acquises par la machine de traitement de cartes qui exécute un traitement de carte prédéterminé sur une carte de circuit imprimé, par rapport au traitement de carte après l'obtention d'un résultat d'inspection, sur la base du résultat d'inspection, dans lequel le résultat d'inspection est obtenu d'un inspecteur inclus dans la ligne de traitement de cartes,
dans lequel l'inspecteur est configuré pour obtenir le résultat d'inspection en inspectant si le traitement de carte est bon ou n'est pas bon dans la machine de traitement de cartes, dans lequel le résultat d'inspection est obtenu d'un inspecteur d'apparence situé à une extrémité de la ligne de traitement de cartes, dans lequel l'inspecteur d'apparence est disposé en aval d'un four de refusion de la ligne de traitement de cartes, et dans lequel l'inspecteur d'apparence est configuré pour reconnaître l'adéquation et les états de montage de chacun des multiples composants montés sur la carte,
dans lequel l'étape d'instruction (S13) comprend une commande de réduction du nombre de bits de gradation des données d'image quand le résultat d'inspection est bon par rapport au cas où le résultat d'inspection n'est pas bon.
